# EUROPEAN PATENT SPECIFICATION

(11) **EP 1 331 486 B1**
(45) Date of publication and mention of the grant of the patent: **05.11.2008**
(21) Application number: 02001187.0
(22) Date of filing: 29.01.2002
(51) Int. Cl.: G01R 31/28

(54) **Testing system for a domestic appliance**
Prüfsystem für ein Haushaltsgerät
Système de test pour appareil électroménager

(43) Date of publication of application: 30.07.2003
(73) Proprietor: WHIRLPOOL CORPORATION, Benton Harbor Michigan 49022 (US)
(72) Inventor: Turrin, Claudio, 21025 Comerio (IT); Binda, Edoardo, 21025 Comerio (IT); Filetti, Claudio, 21025 Comerio (IT); Watzlawik, Juergen, 21025 Comerio (IT)
(74) Representative: Guerci, Alessandro

(56) References cited:
- DE-A- 19 936 674
- PATENT ABSTRACTS OF JAPAN vol. 2000, no. 19, 5 June 2001 (2001-06-05) & JP 2001 046781 A (MATSUSHITA ELECTRIC IND CO LTD), 20 February 2001 (2001-02-20)

## Description

The present invention relates to a testing system for testing a domestic appliance having a electronic board and to a method which makes use of the above testing system. This latter is particularly suitable for testing washing machines at the end of the production line.

It is well known in the art of domestic appliances the need of testing products at the end of the production line in order to avoid selling products which could have quality problems, with the subsequent need of recalling or servicing such appliances at the client's premises. This is particularly true for appliances like washing machines or dishwashers whose malfunction could create problems of leakage of water with consequent damages to client's property. Up to now many producers do not test all the appliances at the end of the line, or they test only some functions thereof (for instance their water tightness) since a full test of all appliances produced would be impractical and would increase the production cycle time. Therefore many producers adopt a "random" check at the end of the production line, i.e. some appliances are picked up and fully tested in a complete program of the appliance. This methodology does not guarantee a 100% quality of the products turned out by the factory.

The document DE 199 36 674 discloses a programmable household device having a controller with reduced memory needs.

An object of the invention is to provide a system that can test 100% of the appliances at the end of the production line in a very quick and reliable way. Another object of the invention is to provide a system in which the testing procedure and parameters thereof can be changed very easily on the basis of the specific model of appliance or on the basis of any specific "weakness" of the appliance. A further object of the invention is to provide a testing system that can be advantageously used in the development phase of a new appliance. A further object of the invention is to provide an appliance that is capable of being tested in a very quick and reliable way, either at the end of production line thereof, or during its normal working life in case the need of servicing it may arise.

According to one aspect of the invention, a testing system is characterised by the features listed in the appended claim 1.

According to further aspects of the invention, there are also provided a method for testing a domestic appliance and a domestic appliance adapted to be tested according to the present invention.

An embodiment of the invention will now be described with reference to the accompanying drawings, in which:
- Figure 1 is a schematic view of an appliance (in the disclosed example washing machine) tested with the system according to the present invention;
- Figure 2 is a schematic diagram showing the electronic board of an appliance connected to the external testing electronic system;
- Figure 3 is a flow diagram showing how the testing electronic system works, i.e. by using a polling cycle performed by the microprocessor of the appliance and by an external unit of the testing system.

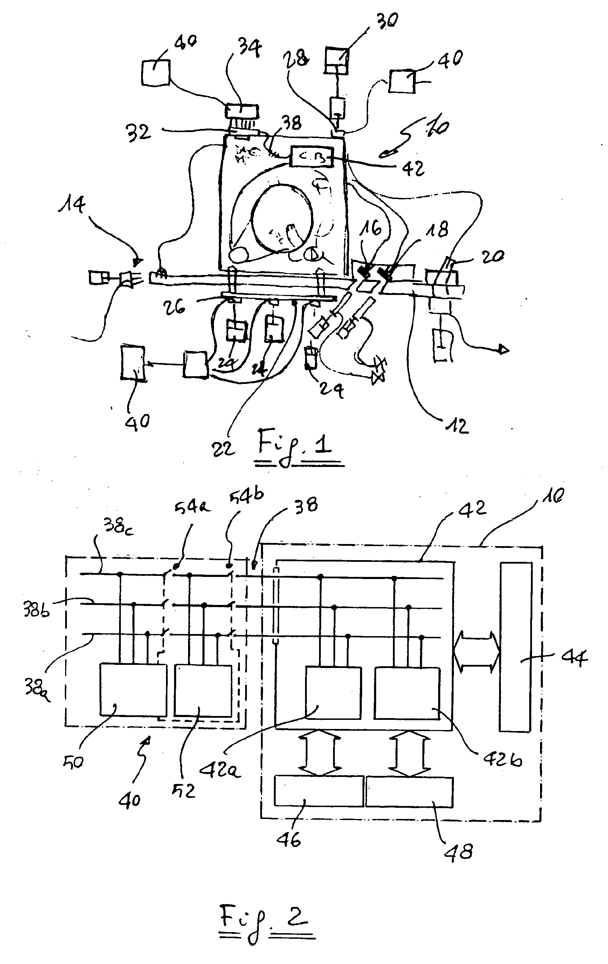

In Figure 1 a washing machine 10 is placed on a moving pallet 12 which has reached one of several testing spots put in parallel at the end of the production line. The pallet 12 can be plugged in 14 to the mains, and has hydraulic connections 16 and 18 for inlet water (cold and hot) and a connection 20 for discharging water. Under the pallet 12, in the testing spot, there is provided a system 22 for lifting the washing machine by means of pneumatic cylinders 24 on whose shaft there are provided strain gauges 26 for measuring the weight of the machine (and therefore its water content).

A vibration sensor 28 is urged against the upper horizontal panel of the washing machine by means of a pneumatic cylinder 30 and its function is to assess any unbalance of the machine, particularly in spinning condition.

In a seat provided in the upper part of the machine, it is placed a connector 32 that cooperates with a corresponding plug 34 having a series of pins or prongs. The plug 34 is connected through a bus 38 to an electronic testing system 40 (figure 2), while the connector 32 is connected, through the same bus 38, to an electronic board 42 of the washing machine 10. The bus 38 is preferably the I²C-bus (known also as Inter-IC bus) developed by Philips and used extensively in a variety of microcontroller-based professional, consumer and telecommunications applications. Of course other buses can be used, for instance IEEE 1394 bus, USB, CAN.bus without departing from the scope of the invention. In the example shown in figure 2 the I²C-bus 38 has three wires, a first wire 38a for clock (SCL, serial clock line), a second wire 38b for data (SDA, serial data line) and a third wire 38c for ground connection.

The electronic board 42 of the washing machine 10 (figure 2) comprises an internal EEPROM 42a and a microprocessor 42b that controls all the functions and programs of the machine. Moreover the electronic board 42 of the appliance is connected to an user interface 44, to sensing components 46 (for instance pressure sensors for assessing the water level, water temperature levels, motor temperature etc.) and to functional components 48 (for instance electrical valves, motor, heating elements etc.). Among sensing components 46, also components used only during the testing procedure of the washing machine 10, as the vibration sensor 28, are included.

The electronic testing system 40 comprises a process logic circuit (PLC) 50 (including a microprocessor) and a non-volatile memory 52, such as a random access memory (RAM) both linked to the I²C-bus 38. The connection of the RAM 52 to the I²C-bus 38 is between the PLC 50 and the electronic board 42 of the appliance so that two electronic switches 54a and 54b, driven by the PLC 50, can control the flow of data to and from the RAM 52. The electronic switches on the bus 38 connect the microprocessor 42b to the RAM 52 and at the same time disconnect the RAM 52 from the electronic board 42 of the washing machine 10 and vice versa. In other words, the communication to and from the PLC 50 is carried out through the RAM 52, the electronic switches 54a and 54b being controlled by the PLC 50 according to a predetermined polling cycle.

During the testing procedure of the washing machine 10, the PLC 50 (which is preferably placed in a control room for the testing of each washing machine) performs reading and writing operations in the RAM 52 and manages the sharing of the RAM 52 of the electronic testing system 40 between the RAM itself and PLC 50. The RAM 52 is used as a mailbox for the data exchange between the RAM 52 and the microprocessor 42b of the electronic board 42. The microprocessor 42b of the electronic board 42 of the washing machine 10 performs reading and writing operations in the RAM 52. The transferring of the information between the microprocessor 42b and the PLC 50 of the electronic testing system 40 is performed through a polling cycle by means of the electronic switches 54a and 54b on the I²C-bus 38. The polling cycle (that has a preferable cycle time of about 500 ms) consists of one reading operation followed by one writing operation; both the operations are performed on the RAM 52. This avoids any conflict between the PLC 50 of the electronic testing system 40 and the microprocessor 42b of the washing machine under testing.

The microprocessor 42b of the washing machine 10 is designed for being able to verify the presence of an external RAM and, if such presence is detected, then the microprocessor 42b is able to work in a so called "external modality" which is different from the standard washing modality. When the presence of the RAM 52 is detected, the microprocessor 42b is in a "slave" condition, i.e. in a condition in which it recognises the data written in RAM 52 by the PLC 50 (either commands or enquires) as the ones controlling its operation, and therefore the operation of the washing machine. Other than for the final check of the appliance at the end of its production line, the "external modality" can be used in all situations where it is necessary to have a dialogue between the appliance and the external world, for instance in the maintenance service, in the test carried out by the supplier of the electronic board of the appliance or when it is necessary to develop new working cycles of the appliance.

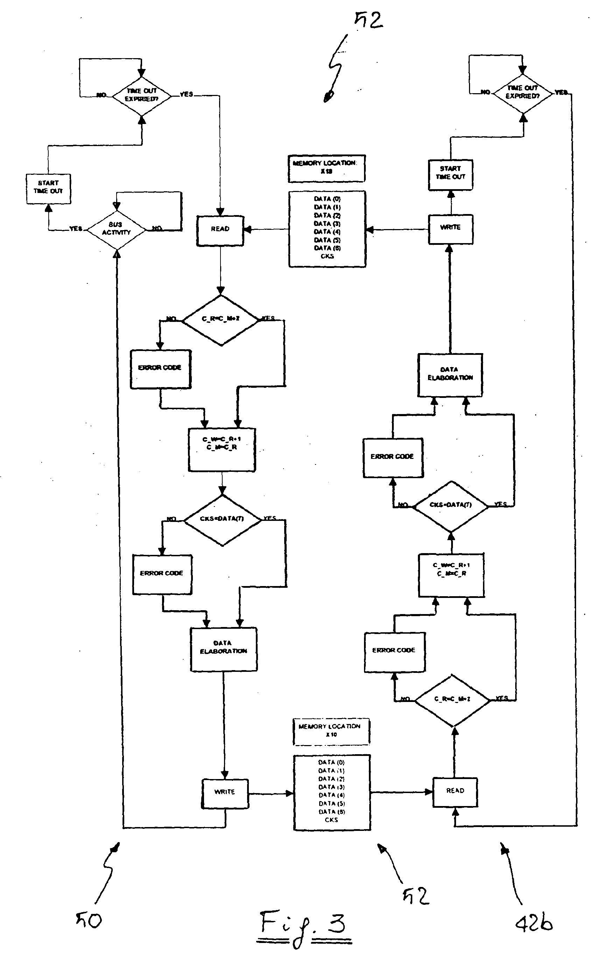

The polling cycle performed by the microprocessor 42b and by the PLC 50 is shown in the flow chart of figure 3, where C_R means "counter read", C_M means "counter memorised" and C_W means "counter written". In DATA(0) is located the type of information exchanged between the microprocessor 42b of the washing machine 10 and the PLC 50 of the electronic testing system 40. There can be the following situations:
- DATA(0) is a command. If the command is correct, the microprocessor 42b performs two operations: re-writing of the command previously read on the PLC 50 and elaboration and execution of the command. If command is not correct, the microprocessor 42b writes an error code.
- DATA(0) is an enquire. If enquire is correct, the microprocessor 42b performs two operations: re-writing of the enquire previously read added the information enquired (if it is available) and elaboration of the data enquired for the next enquiring. If enquire is not correct the microprocessor 42b writes an error code.

Summing up the above situations, the microprocessor 42b informs the PLC 50 whether a command or an enquire have been performed correctly or not.

After the power up of the washing machine 10, the microprocessor 42b performs the following two operations:
- initialisation of the EEPROM 42a;
- verify the presence of the external RAM 52 in order to set itself to the "external modality"

In order to maintain the link between the PLC 50 and the microprocessor 42b through the I²C-bus 38, the following conditions must be satisfied:
- the microprocessor 42b has to recognise the presence of the external RAM 52 during each polling cycle;
- the difference between the value of the DATA counter read in the current polling cycle and the value of the DATA counter read in the previous polling cycle must not exceed a pre-defined value.

The DATA counter is stored in the first 4 bits of the DATA(0), and it is used to check if the testing section is active.

The conditions to end the testing connection are the following: the microprocessor 42b recognises command of stop testing and then ends the polling operation, or it has been detected a protocol error for a predetermined number of time (for instance 100) consecutively.

Every single component of the washing machine 10 can be switched on and off by means of a specific command, and it is preferable that the sequence of commands respect precise rules and procedure. The testing system 40 inquires the microprocessor 42b to know the value of analogic sensors, digital sensors and software codes of the washing machine 10. Only one command and only one enquiry of DATA can be processed per single polling operation. A non-exhaustive list of components which can be driven by the PLC 50 through the RAM 52 comprises heating element, discharge pump, re-circulation pump, valves for cold and hot water, motor, detergent distributor system, door lock, leds, segments display, buzzer. A non-exhaustive list of data which can be requested by the PLC 50 through the RAM 52 comprises the status of door switch, flow meter output, speedometer output, pressure switch, status of distributor system, temperature in the tank, inlet temperature, door lock status, heating system status, re-circulation pump status, heating system status, unbalance ramp, unbalance constant speed, concentrated unbalance load, anti-leakage device status, drum up status, motor initialisation.

Even if the above disclosure focuses on the testing of an appliance as a whole, the testing system can be used for testing only a component thereof, particularly the electronic board of the appliance. This further embodiment of the invention differs from the previous one only in that the links of the electronic board 42 to the sensing components, functional components and user interface are virtual links. In other words, the electronic board 42 of the appliance is connected to a specific electronic component or group of components which act as a washing machine (the electronic board 42 of the appliance cannot distinguish if it is connected to an actual washing machine or to a virtual one). Such embodiment is particularly suitable when the electronic board of the appliance has to be tested by the supplier of the electronic board itself.

An appliance according to the present invention, i.e. an appliance which can verify the presence of an external memory and can put itself in an auxiliary modality different from the standard working modality, is particularly useful not only for testing, but also for development and design purposes. An appliance according to the invention can be easily connected to a system substantially identical or similar to the testing system disclosed above, not for testing rather for tailoring the working program of the appliance in an easy way without the need of changing or re-designing the microprocessor of the electronic board of the appliance. This can help in the design of a new appliance or in the updating of a known one, since the change of working parameters can be carried out very quickly.

The testing system and the method according to the invention may be implemented on all kind of domestic appliances, including but not limited to washing machines, dishwashers, dryers, cooking appliances such as cooking hobs or domestic ovens, refrigerators, freezers, and microwave ovens.

## Claims

1. A testing system for testing an electronic board (42) of a domestic appliance (10), particularly a washing machine, comprising an electronic system (40) having a microprocessor (50) and a RAM (52), a bus (38) adapted to connect the electronic board (42) of the appliance (10) to the electronic system (40), **characterized in that** said electronic testing system further comprises electronic switches (54a, 54b) on said bus (38), said switches being controlled by the microprocessor (50) and adapted to connect the microprocessor (50) to the RAM (52) and, at the same time, to disconnect the RAM (52) from the electronic board (42) of the appliance (10) and vice versa, so that the electronic system is able to control the domestic appliance (10) through said RAM (52), wherein the communication to and from the microprocessor (50) is carried out through the RAM (52).

2. The testing system according to claim 1, further **characterised in that** the electronic switches (54a, 54b) are controlled through a predetermined polling cycle.

3. The testing system according to claim 1, further **characterised in that** said bus is an I²C-bus.

4. The testing system according to any of the preceding claims, further **characterised in that** the electronic system (40) is connected to a vibration sensor (28) urged against a portion of the appliance (10).

5. A method for testing an electronic board (42) of a domestic appliance (10), particularly of a washing machine, comprising the steps of connecting the electronic board (42) of the appliance (10) to a testing system comprising an electronic system (40) having a microprocessor (50) and a RAM (52), controlling the input and output of data in and from said RAM (52) **characterized in that** the step of controlling the input and output of data in and from said RAM (52) is accomplished by means of electronic switches (54a, 54b) driven by said microprocessor (50), so that when the electronic board (42) writes or reads data on or from the RAM (52), this latter is disconnected from the microprocessor (50) and when the microprocessor (50) reads or writes data from or on the memory, this latter is disconnected from the electronic board (42).

6. The method according to claim 5, further **characterised in that** the switching of the electronic switches (54a, 54b) is carried out according to a polling cycle.

7. A domestic appliance having an electronic board (42), comprising a bus connection (38) and a microprocessor (42b) capable to work in a external modality different from a standard modality, **characterized in that** said microprocessor (42b) is designed for being able to verify the presence of an external RAM (52) comprised in a testing system as disclosed in claim 1, and also **characterized in that** when such presence is detected the microprocessor (42b) is able to work in the external modality, wherein the external modality is such that the microprocessor (42b) recognises the data written in the external RAM (52) as the ones controlling its operation.

## Patentansprüche

1. Testsystem zum Testen einer Leiterplatte (42) eines Haushaltgeräts (10), insbesondere einer Waschmaschine, umfassend ein elektronisches System (40) mit einem Mikroprozessor (50) und einem RAM (52), einen Bus (38), der ausgelegt ist zum Verbinden der Leiterplatte (42) des Geräts (10) mit dem elektronischen System (40), **dadurch gekennzeichnet, dass** das elektronische Testsystem ferner elektronische Schalter (54a, 54b) auf dem Bus (38) umfasst, wobei die Schalter durch den Mikroprozessor (50) gesteuert werden und ausgelegt sind, den Mikroprozessor (50) mit dem RAM (52) zu verbinden, und zur gleichen Zeit, den RAM (52) von der Leiterplatte (42) des Geräts (10) und umgekehrt zu trennen, so dass das elektronische System in der Lage ist, das Haushaltsgerät (10) über den RAM (52) zu steuern, wobei die Kommunikation zu und von dem Mikroprozessor (50) über den RAM (52) durchgeführt wird.

2. Testsystem nach Anspruch 1, ferner **dadurch gekennzeichnet, dass** die elektronischen Schalter (54a, 54b) über einen vorbestimmten Abfragezyklus gesteuert werden.

3. Testsystem nach Anspruch 1, ferner **dadurch gekennzeichnet, dass** der Bus ein I²C-Bus ist.

4. Testsystem nach irgendeinem der vorhergehenden Ansprüche, ferner **dadurch gekennzeichnet, dass** das elektronische System (40) mit einem Schwingungssensor (28) verbunden ist, der gegen einen Teil des Geräts (10) gedrückt wird.

5. Verfahren zum Testen einer Leiterplatte (42) eines Haushaltgeräts (10), insbesondere einer Waschmaschine, die Schritte umfassend zum Verbinden der Leiterplatte (42) des Geräts (10) mit einem ein elektronisches System (40) mit einem Mikroprozessor (50) und einem RAM (52) umfassenden Testsystem zum Steuern der Eingabe und Ausgabe von Daten in uns aus dem RAM (52), **dadurch gekennzeichnet, dass** der Schritt zum Steuern der Eingabe und Ausgabe von Daten in und aus dem RAM (52) erreicht wird durch eine Einrichtung von durch den Mikroprozessor (50) angesteuerten elektronischen Schaltern (54a, 54b), so dass, wenn die Leiterplatte (42) Daten auf oder von dem RAM (52) schreibt oder liest, der Letztere von dem Mikroprozessor (50) getrennt wird, und wenn der Mikroprozessor (50) Daten von oder auf den Speicher liest oder schreibt, der Letztere von der Leiterplatte (42) getrennt wird.

6. Verfahren nach Anspruch 5, ferner **dadurch gekennzeichnet, dass** das Schalten der Schalter (54a, 54b) gemäß einem Abfragezyklus durchgeführt wird.

7. Haushaltgerät mit einer Leiterplatte (42), eine Busverbindung (38) und einen Mikroprozessor (42b) umfassend, die in der Lage sind, in einer sich von der Standardmodalität unterscheidenden externen Modalität zu arbeiten, **dadurch gekennzeichnet, dass** der Mikroprozessor (42b) ausgelegt ist, in der Lage zu sein, das Vorhandensein eines externen RAM (52) zu verifizieren, den ein wie in Anspruch 1 offenbartes Testsystem umfasst, und auch **dadurch gekennzeichnet, dass,** wenn ein solches Vorhandensein erfasst wird, der Mikroprozessor (42b) in der Lage ist, in der externen Modalität zu arbeiten, wobei die externe Modalität so ausgelegt ist, dass der Mikroprozessor (42b) die in den externen RAM (52) geschriebenen Daten als diejenigen erkennt, die seinen Betrieb steuern.

## Revendications

1. Système de test pour tester une carte électronique (42) d'un appareil électroménager (10), en particulier une machine à laver, comprenant un système électronique (40) comportant un microprocesseur (50) et une RAM (52), un bus (38) adapté pour relier la carte électronique (42) de l'appareil (10) au système électronique (40), **caractérisé en ce que** ledit système de test électronique comporte en outre des commutateurs électroniques (54a, 54b) sur ledit bus (38), lesdits commutateurs étant contrôlés par le microprocesseur (50) et adaptés pour relier le microprocesseur (50) à la RAM (52) et, simultanément, pour déconnecter la RAM (52) de la carte électronique (42) de l'appareil (10) et vice versa, de sorte que le système électronique peut contrôler l'appareil électroménager (10) par l'intermédiaire de ladite RAM (52), dans lequel la communication vers et depuis le microprocesseur (50) est effectuée par l'intermédiaire de la RAM (52).

2. Système de test selon la revendication 1, **caractérisé en outre en ce que** les commutateurs électroniques (54a, 54b) sont contrôlés par l'intermédiaire d'un cycle d'interrogation prédéterminé.

3. Système de test selon la revendication 1, **caractérisé en outre en ce que** ledit bus est un bus I²C.

4. Système de test selon l'une quelconque des revendications précédentes, **caractérisé en outre en ce que** le système électronique (40) est relié à un capteur de vibrations (28) pressé contre une partie de l'appareil (10).

5. Procédé de test d'une carte électronique (42) d'un appareil électroménager (10), en particulier d'une machine à laver, comportant les étapes consistant à relier la carte électronique (42) de l'appareil (10) à un système de test comportant un système électronique (40) comprenant un microprocesseur (50) et une RAM (52), à contrôler l'entrée et la sortie de données dans et depuis ladite RAM (52) **caractérisé en ce que** l'étape consistant à contrôler l'entrée et la sortie de données dans et depuis ladite RAM (52) est effectuée au moyen de commutateurs électroniques (54a, 54b) commandés par ledit microprocesseur (50), de sorte que, lorsque la carte électronique (42) écrit ou lit des données sur ou depuis la RAM (52), cette dernière est déconnectée du microprocesseur (50) et lorsque le microprocesseur (50) lit ou écrit des données depuis ou sur la mémoire, cette dernière est déconnectée de la carte électronique (42).

6. Procédé selon la revendication 5, **caractérisé en outre en ce que** la commutation des commutateurs électroniques (54a, 54b) est effectuée par l'intermédiaire d'un cycle d'interrogation.

7. Appareil électroménager possédant une carte électronique (42), comprenant une connexion par bus (38) et un microprocesseur (42b) pouvant fonctionner selon une modalité externe différente d'une modalité standard, **caractérisé en ce que** ledit microprocesseur (42b) est conçu pour pouvoir vérifier la présence d'une RAM externe (52) comprise dans un système de test comme décrit dans la revendication 1, et également **caractérisé en ce que**, lorsque cette présence est détectée, le microprocesseur (42b) peut fonctionner selon la modalité externe, où la modalité externe est telle que le microprocesseur (42b) reconnaît les données écrites dans la RAM externe (52) en tant que celles contrôlant son fonctionnement.
